# EUROPÄISCHE PATENTSCHRIFT

(11) **EP 0 978 691 B1**
(45) Veröffentlichungstag und Bekanntmachung des Hinweises auf die Patenterteilung: **12.09.2007**
(21) Anmeldenummer: 99114988.1
(22) Anmeldetag: 31.07.1999
(51) Int. Cl.: H01L 21/00, F24F 3/16

(54) **Reinraum**
Clean room
Salle blanche

(30) Priorität: 06.08.1998 DE 19835538
(43) Veröffentlichungstag der Anmeldung: 09.02.2000
(73) Patentinhaber: M+W Zander Facility Engineering GmbH + Co. KG, 70499 Stuttgart (DE)
(72) Erfinder: Renz, Manfred, Dr., 71254 Ditzingen (DE)
(74) Vertreter: Kohl, Karl-Heinz

(56) Entgegenhaltungen:
- EP-A- 0 195 703
- PATENT ABSTRACTS OF JAPAN Bd. 010, Nr. 176 (M-491), 20. Juni 1986 (1986-06-20) & JP 61 024933 A (TOSHIBA CORP), 3. Februar 1986 (1986-02-03)
- PATENT ABSTRACTS OF JAPAN Bd. 007, Nr. 244 (M-252), 28. Oktober 1983 (1983-10-28) & JP 58 129123 A (HITACHI SEISAKUSHO KK), 2. August 1983 (1983-08-02)
- PATENT ABSTRACTS OF JAPAN Bd. 018, Nr. 147 (M-1575), 11. März 1994 (1994-03-11) & JP 05 322248 A (MATSUSHITA ELECTRIC IND CO LTD), 7. Dezember 1993 (1993-12-07)

## Beschreibung

Die Erfindung betrifft einen Reinraum nach dem Oberbegriff des Anspruches 1.

Es ist bekannt, in einem Reinraum Wafer mit Chemikalien an Prozeßgeräten oder Prozeßflächen zu behandeln. Hierbei werden gasförmige Substanzen freigesetzt, die von der durch den Reinraum strömenden Reinluft mitgenommen werden. Da im Reinraum unterschiedliche Prozeßgeräte und/oder Prozeßflächen stehen, an denen unterschiedliche Bearbeitungen an den Wafern vorgenommen werden, kann die im Umluftverfahren strömende Reinluft die unterschiedlichsten Gasbestandteile enthalten. Sie können dazu führen, daß Störungen bei der Behandlung von Wafern an einzelnen Prozeßgeräten und/oder Prozeßflächen auftreten. Es ist bekannt, mit chemisorptiv und/oder adsorptiv wirkenden Filterstufen solche gasförmigen Bestandteile aus der Umluft des Reinraumes zu entfernen. Die Vielzahl der von den Prozessen in den Reinraum emittierten Chemikalien macht es jedoch schwierig und teuer, alle diese Stoffe in dem erforderlichen Umfang wieder aus der Umluft zu entfernen. Es ist zudem häufig schwierig, auftretende Störungen bei einzelnen Bearbeitungsschritten bestimmten Schadstoffen in der Umluft zuzuordnen, so daß eine optimale Auslegung entsprechender Filterstufen erschwert wird.

Es ist ein Reinraum bekannt (Patent Abstracts of Japan Bd. 010, Nr. 176 (M-491), 20. Juni 1986 (1986-06-20) & JP 61 024933 A (Toshiba Corp), 3. Februar 1986 (1986-02-03)), bei dem einem Prozeßgerät über einen Sammelkanal getrennt von der Umluft ein gasförmiges Medium zugeführt wird. Befinden sich mehrere Prozeßgeräte im Reinraum, wird jedem Prozeßgerät über jeweils einen Sammelkanal das gasförmige Medium zugeleitet. Der technische und konstruktive Aufwand ist groß.

Der Erfindung liegt die Aufgabe zugrunde, den gattungsgemäßen Reinraum so auszubilden, daß bei einfacher Ausbildung eine einwandfreie Behandlung an dem jeweiligen Prozeßgerät und/oder der Prozeßfläche gewährleistet ist.

Diese Aufgabe wird beim gattungsgemäße Reinraum erfindungsgemäß mit den kennzeichnenden Merkmalen des Anspruches 1 gelöst.

Beim erfindungsgemäßen Reinraum wird in dem Bereich, in dem ein sensibler Prozeß stattfindet, getrennt von der Reinluft bzw. Umluft das gasförmige Medium zugeführt, dessen chemische Zusammensetzung bekannt ist. Dadurch kann das gasförmige Medium optimal gereinigt werden, da die entsprechenden Filterbestandteile auf die Bestandteile des gasförmigen Mediums einfach abgestimmt werden können. Die Behandlung des gasförmigen Mediums wird dabei auf diejenige Menge beschränkt, die zur Versorgung der sensiblen Prozeßflächen erforderlich ist. Durch die Abtrennung des Gasstromes für die sensiblen Prozeßflächen vom Umluftstrom des Reinraumes ist gewährleistet, daß Störungen an verschiedenen Prozeßgeräten und/oder Prozeßflächen innerhalb des Reinraumbereiches zuverlässig vermieden werden. Das gasförmige Medium wird über den Zuführraum den unterschiedlichen Prozeßgeräten/Prozeßflächen zugeführt, wodurch sich eine konstruktiv einfache und kostengünstige Ausbildung ergibt. Das gasförmige Medium wird vom Sammelkanal dem Zuführraum zugeleitet, von dem aus das gasförmige Medium über die Strömungsräume zu den Prozeßgeräten/Prozeßflächen gelangt. Das gasförmige Medium wird vorteilhaft vor der Zuführung zum Prozeßgerät und/oder zur Prozeßfläche aufbereitet, beispielsweise gekühlt oder erwärmt, befeuchtet oder entfeuchtet oder beispielsweise auch gefiltert.

Weitere Merkmale der Erfindung ergeben sich aus den weiteren Ansprüchen, der Beschreibung und den Zeichnungen.

Die Erfindung wird anhand zweier in den Zeichnungen dargestellter Ausführungsbeispiele näher erläutert. Es zeigen
- Fig. 1: in schematischer Darstellung im Querschnitt eine erste Ausführungsform eines erfindungsgemäßen Reinraumes,
- Fig. 2: in einer Darstellung entsprechend Fig. 1 eine zweite Ausführungsform eines erfindungsgemäßen Reinraumes,
- Fig. 3: in schematischer Darstellung eine Filtereinheit des erfindungsgemäßen Reinraumes.

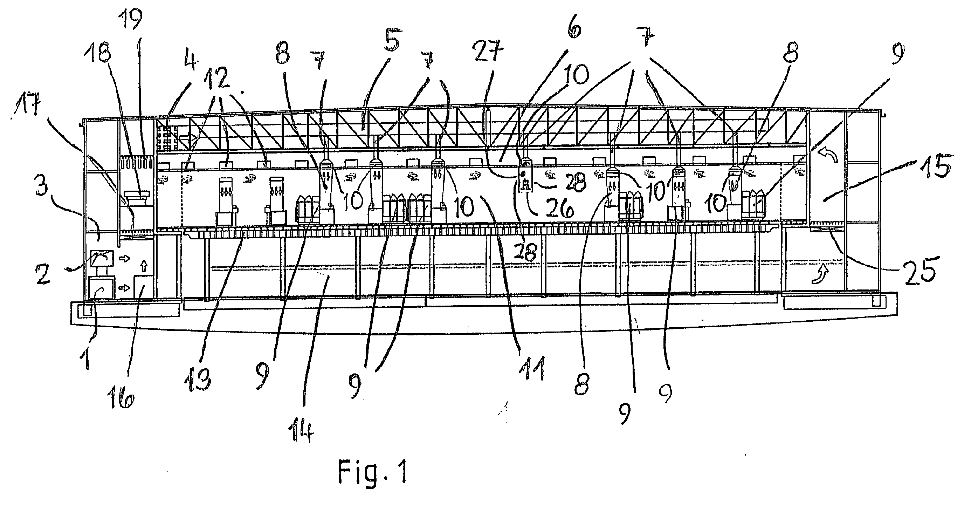

Bei der Ausführungsform gemäß Fig. 1 wird die atmosphärische Luft als gasförmiges Medium von mindestens einem Außenluftgerät 1 angesaugt, dem ein Außenluftsammelkanal 2 nachgeschaltet ist. Vorteilhaft bilden das Außenluftgerät 1 und der Sammelkanal 2 eine Baueinheit, die in einem Geräteraum 3 angeordnet ist. Dem Außenluftgerät 1 ist mindestens eine chemi-/adsorptive Filtereinheit 4 nachgeschaltet, in der die Luft in noch zu beschreibender Weise aufbereitet wird. Im Anschluß an die Filtereinheit 4 gelangt die aufbereitete Luft in wenigstens einen Kanal 5, der sich im Bereich oberhalb eines Plenums 6 befindet. An den Kanal 5 sind Leitungen 7 angeschlossen, die nach unten in das Plenum 6 ragen und über wenigstens ein Schwebstoffilter 10 in Strömungsräume 8 münden, durch welche die aufbereitete Luft zu Prozeßgeräten 9 und/oder Prozeßflächen geführt wird. Die Prozeßgeräte 9 und die Prozeßflächen befinden sich im Reinraum 11. Er wird von Reinluft durchströmt, die aus Filter-Ventilator-Einheiten 12 nach unten strömt, die im Deckenbereich des Reinraumes 11 in bekannter Weise angeordnet sind. Sowohl die Reinluft als auch die durch die Strömungsräume 8 strömende aufbereitete Luft gelangen durch einen gelochten Boden 13 des Reinraumes 11 in einen Sammelraum 14, in dem sich die Reinluft mit der aufbereiteten Luft vermischt und in Richtung der eingezeichneten Pfeile über einen aufwärts verlaufenden Zuführkanal 15 in das Plenum 6 strömt. Diese Umluft wird in bekannter Weise mittels der Filter-Ventilator-Einheiten 12 angesaugt und vor ihrem Eintritt in den Reinraum 11 gefiltert. Der Zuführkanal 15 ist vom Kanal 5 abgetrennt.

Die Strömungsräume 8 sind in den Bereichen vorgesehen, in denen ein für molekulare Verunreinigung und/oder für Feuchte-/Temperaturkonditionen sensibler Prozeß stattfindet. Über diese Strömungsräume 8 wird in diesen Bereichen aufbereitete Außenluft zugeführt, deren chemische Zusammensetzung bekannt ist. Die chemische Zusammensetzung der Umluft entspricht wenigstens der chemischen Zusammensetzung der in den Reinraum eingespeisten Außenluft. Außenluft ist ein kostengünstiges Gas und kann darum bevorzugt zur Versorgung der Prozeßgeräte und/oder Prozeßflächen eingesetzt werden. Die Nachbehandlung der Außenluft ist außerdem kostengünstiger und einfacher als die Nachbehandlung der Umluft. Auf diese Weise können die molekularen Verunreinigungen einwandfrei entfernt werden. Selbstverständlich können auch andere gasförmige Medien, wie zum Beispiel Reinststickstoff, über die Strömungsräume 8 den Prozeßgeräten 9 und/oder Prozeßflächen zugeführt werden. Die Strömungsräume 8 werden durch Wände gebildet, die den Behandlungsraum bzw. die Prozeßfläche von der Reinluft des Reinraumes 11 trennen. Die aufbereitete Luft nimmt die an den Prozeßgeräten 9 und/oder den Prozeßflächen bei der Behandlung der Wafer entstehenden Gase bzw. Dämpfe mit. Da die chemische Zusammensetzung der angesaugten Außenluft bekannt ist, kann sie optimal gereinigt werden, da die entsprechenden Filterelemente genau auf die Komponenten der aufbereiteten Luft abgestimmt werden können. Da die Prozeßflächen im Verhältnis zur Reinraumfläche sehr gering sind, sind auch nur sehr geringe Luftmengen erforderlich, um die sensiblen Bereiche 9 innerhalb des Reinraumes 11 mit der aufbereiteten Luft zu versorgen. Die Strömungsräume 8 sind nach unten in Richtung auf den Behandlungsbereich der Prozeßgeräte 9 bzw. Prozeßflächen offen, jedoch so gestaltet, daß die in den Strömungsräumen 8 nach unten strömende aufbereitete Luft nicht mit der Reinluft innerhalb des Reinraumes 11 in Berührung kommt. Aufgrund der optimalen Reinigungsmöglichkeit der aufbereiteten Luft ist sichergestellt, daß in der Reinluft, die durch den Reinraum 11 von oben nach unten strömt, keine schädlichen Bestandteile enthalten sind, die Störungen bei der Behandlung der Wafer verursachen können. Darum können im Reinraum 11 an den verschiedenen Prozeßgeräten 9 bzw. Prozeßflächen die unterschiedlichsten Behandlungen an den Wafern vorgenommen werden.

Dem Außenluftgerät 1 kann ein Ent-/Befeuchtungsgerät 16 nachgeschaltet sein, mit dem unterschiedliche Luftzustände für einzelne Zonen oder Prozeßgeräte hergestellt werden können. Dieses Gerät 16 ist vorteilhaft ebenfalls im Geräteraum 3 untergebracht. Das Ent/Befeuchtungsgerät 16 kann als Kühler ausgebildet oder mit Sorptionselementen, wie Lithiumchlorid, Silicagel, Zeolith und dergleichen, versehen sein. Die Befeuchtung kann in bekannter Weise zum Beispiel durch Ultraschall-, Sprüh-, Riesel-, oder Dampfbefeuchter erfolgen. Das Ent/Befeuchungsgerät 16 kann auch Teil des Außenluftgerätes 1 sein.

Dem Außenluftgerät 1 kann außerdem ein Wärmeübertrager 17 (Kühler/Erhitzer) zur genauen Temperaturregelung spezieller Zonen oder Prozeßgeräte 9 nachgeschaltet sein. Der Wärmeübertrager 17 kann auch zusammen mit dem Ent-/Befeuchtungsgerät 16 im Geräteraum 3 vorgesehen sein.

Um die durch den Wärmeübertrager 17 und/oder die Filterstufen 4 entstehenden Druckverluste zu überwinden, kann wenigstens ein Ventilator 18 vorgesehen werden, der sich in Strömungsrichtung der aufbereiteten Luft hinter dem Wärmeübertrager 17 und/oder dem Ent-/Befeuchtungsgerät 16 befindet.

Im Anschluß an den Ventilator 18 kann ein Schalldämpfer 19 vorgesehen sein, der aus parallel zueinander liegenden und in Strömungsrichtung der aufbereiteten Luft sich erstreckenden Platten gebildet wird.

Die Filtereinheit 4 befindet sich im dargestellten Ausführungsbeispiel am Eingang in den Kanal 5. Je nach Lage und Anordnung der Prozeßgeräte 9 bzw. der Prozeßflächen können mehrere Kanäle 5 vorgesehen sein, über welche die aufbereitete Luft den entsprechenden Prozeßgeräten 9 und Prozeßflächen in der beschriebenen Weise zugeführt wird. Auf jeden Fall strömt die Luft vor dem Eintritt in die verschiedenen Kanäle 5 durch die Filtereinheit 4. Es kann jedem Kanal 5 eine solche Filtereinheit 4 vorgeschaltet sein. Es ist aber auch möglich, nur eine Filtereinheit 4 vorzusehen, durch welche die aufbereitete Luft hindurchgeführt wird, bevor sie zu den einzelnen Kanälen 5 gelangt.

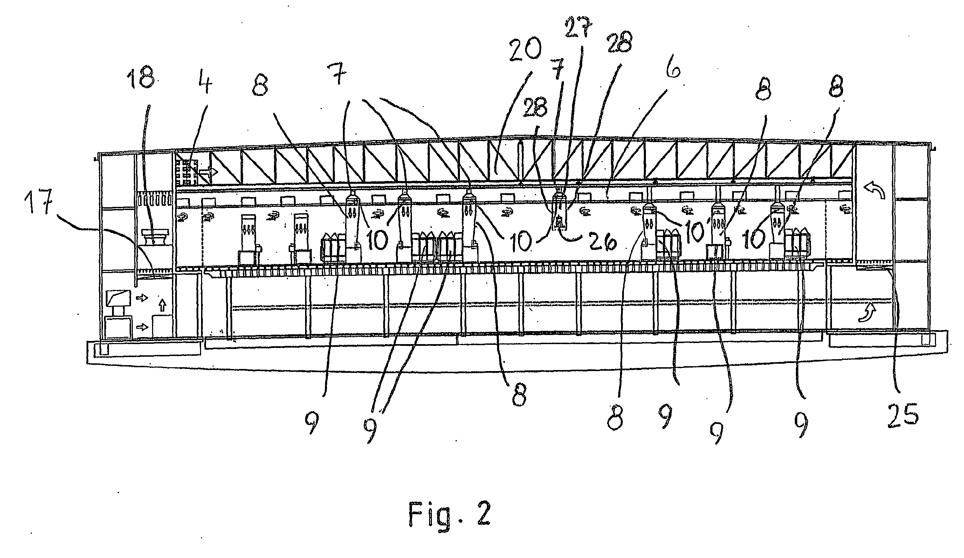

Das Ausführungsbeispiel gemäß Fig. 2 unterscheidet sich von der vorigen Ausführungsform lediglich dadurch, daß anstelle einer oder mehrerer Rohrleitungen 5 wenigstens ein Schacht 20 oder ein Druckplenum vorgesehen ist, in den die aufbereitete Luft strömt. Wie der Kanal 5 ist auch der Schacht 20 vollständig vom Plenum 6 getrennt. Vom Schacht 20 gehen die Leitungen 7 ab, über welche die aufbereitete Luft in der beschriebenen Weise den Prozeßgeräten 9 und/oder den Prozeßflächen über mindestens ein Schwebstoffilter 10 zugeführt wird. Die Leitungen 7 münden in die nach unten führenden Strömungsräume 8, in welchen die aufbereitete Luft direkt zu den Prozeßgeräten 9 und/oder den Prozeßflächen zugeführt wird. Im übrigen arbeitet dieser Reinraum gleich wie die Ausführungsform gemäß Fig. 1.

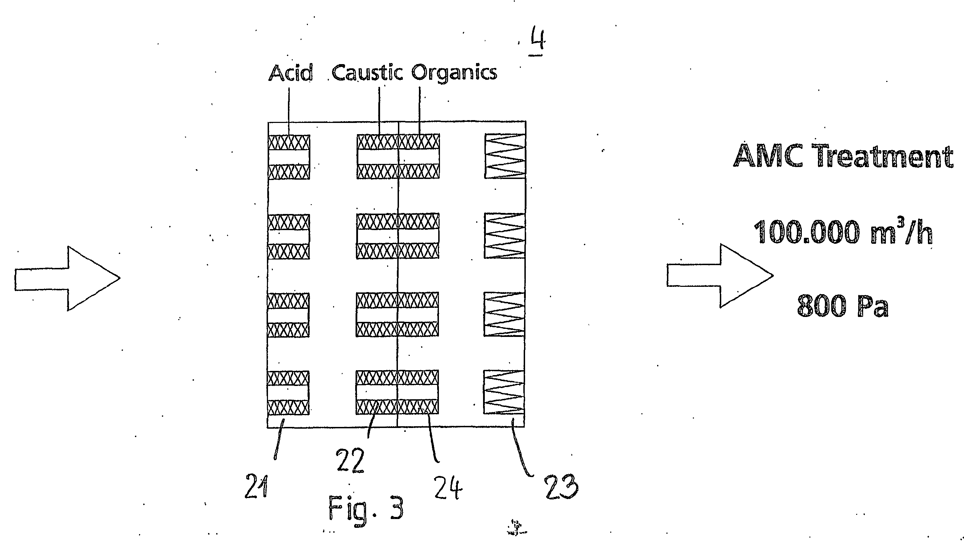

Fig. 3 zeigt den grundsätzlichen Aufbau der Filtereinheit 4. Sie weist wenigstens eine Filterstufe auf. Im dargestellten Ausführungsbeispiel sind vier Filterstufen 21 bis 24 vorgesehen. Mit ihnen können die unterschiedlichen Bestandteile des zugeführten gasförmigen Mediums, insbesondere der Außenluft, gefiltert werden, bevor es in der beschriebenen Weise über die Leitungen 7 und die Strömungsräume 8 zu den Prozeßgeräten 9 und/oder Prozeßflächen geleitet wird. In der Filterstufe 21 werden basische Bestandteile des gasförmigen Mediums abgefangen. Dementsprechend besteht diese Filterstufe 21 aus sauren Bestandteilen.

In der Filterstufe 22 werden saure Bestandteile des gasförmigen Mediums aufgenommen. Die Filterstufe 22 besteht dementsprechend aus basischen Filterkomponenten.

Die Filterstufe 23 wird durch Hochleistungsfilter (HEPA-Filter) gebildet, mit denen Partikel im gasförmigen Medium abgefangen werden.

Die Filtereinheit 4 kann die Filterstufe 24 aufweisen, die aus organischen Filterkomponenten gebildet ist, mit denen organische Bestandteile des gasförmigen Mediums abgefangen werden können.

Beim Durchgang des vom Außenluftgerät 1 kommenden gasförmigen Mediums durch die Filtereinheit 4 werden die sauren, basischen und organischen Bestandteile sowie auch Schmutzteilchen abgefangen, so daß das den Prozeßgeräten 9 und/oder Prozeßflächen zugeführte aufbereitete gasförmige Medium keine schädlichen Bestandteile mehr enthält. Da die Zusammensetzung des zugeführten gasförmigen Mediums bekannt ist, kann die Filtereinheit 4 optimal so ausgebildet werden, daß alle im zugeführten gasförmigen Medium enthaltenen Bestandteile einwandfrei gefiltert werden.

Die Reihenfolge der beschriebenen Filterstufen 21 bis 24 in der Filtereinheit 4 kann variabel sein. Auch können, je nach Zusammensetzung des zugeführten gasförmigen Mediums, eine oder mehrere der Filterstufen entfallen. Bevorzugt wird als gasförmiges Medium Außenluft verwendet, die in großen Mengen kostengünstig zur Verfügung steht. Die Filtereinheit kann beispielhaft so ausgebildet sein, daß sie einen Durchsatz von 100.000 m³/h ermöglicht.

Das aufbereitete gasförmige Medium nimmt die am Prozeßgerät 9 und/oder an der Prozeßfläche bei der Behandlung der Wafer entstehenden gasförmigen Bestandteile und Partikel auf. Ein Teil des gasförmigen Mediums wird aus dem Prozeßgerät 9 und/oder aus der Prozeßfläche einem (nicht dargestellten) Fortluftsystem zugeführt, das damit einen großen Teil der von den Prozessen emittierten Bestandteile entfernt. Der andere Teil des gasförmigen Mediums gelangt nach unten durch den Boden 13 in den Sammelraum 14. Dort vermischt sich dieses gasförmige Medium mit der Reinluft, die den übrigen Bereich des Reinraumes 11 von oben nach unten durchströmt. Die Filter-Ventilator-Einheiten 12 filtern die aufgenommenen partikelförmigen Bestandteile einwandfrei aus.

Am Übergang vom horizontalen Sammelraum 14 in den vertikalen Zuführkanal 15 befindet sich vorteilhaft mindestens ein Wärmeübertrager 25 (Fig. 1 und 2), mit dem eine genaue Temperaturregelung der den Filter-Ventilator-Einheiten 12 zugeführten Reinluft möglich ist.

Wenn für die Zuführung des aufbereiteten gasförmigen Mediums mehrere horizontal nebeneinander liegende Kanäle 5 oder Schächte 20 vorgesehen sind, ist der Ventilator 18 besonders vorteilhaft. Er überwindet nicht nur die zusätzlichen Druckverluste durch den Wärmeübertrager 17 und die Filtereinheit 4, sondern ist auch dann von Vorteil, wenn das Außenluftgerät 1 mehrere parallel angeordnete Kanäle 5 oder Schächte 20 versorgt und beispielsweise nur die Außenluft aus einem Kanal 5 oder einem Schacht 20 über zusätzliche chemi-/adsorptive Filterstufen geführt wird.

Die im Plenum 6 befindlichen Filter-Ventilator-Einheiten 12 sind vom Kanal 5 bzw. vom Schacht 20 getrennt, so daß eine gegenseitige Beeinflussung der Reinluft und des aufbereiteten gasförmigen Mediums ausgeschlossen ist.

Wie die Fig. 1 und 2 beispielhaft zeigen, ist an der Decke des Reinraumes 11 ein Transportweg 26 für die Wafer vorgesehen, um sie innerhalb des Reinraumes zu transportieren. Der Transportweg 26 liegt in einem Strömungsraum 27, der nach unten in den Reinraum 11 offen und seitlich von Wänden 28 begrenzt ist. Der Strömungsraum 27 ist über wenigstens eine Leitung 7 und wenigstens ein Schwebstoffilter 10 mit dem Kanal 5 bzw. dem Schacht 20 verbunden. Somit wird auch der Strömungsraum 27 vom aufbereiteten gasförmigen Medium durchströmt.

Das aufbereitete gasförmige Medium wird vorteilhaft auch in solchen Bereichen des Reinraumes 11 vorgesehen, in denen die Wafer längere Zeit zwischengelagert werden.

## Patentansprüche

1. Reinraum, der von Reinluft/Umluft durchströmt ist, in dem sich mindestens ein Prozeßgerät (9) und/oder mindestens eine Prozeßfläche befinden, denen über mindestens ein Ansauggerät (1), an das ein Sammelkanal (2) angeschlossen ist, ein gasförmiges Medium mit bekannter Zusammensetzung über einen Strömungsraum (8) zuführbar ist, das getrennt von der Umluft zuführbar ist,
**dadurch gekennzeichnet, daß** der Sammelkanal (2) mit einem Zuführraum (5, 20) strömungsverbunden ist, an den mehrere Strömungsräume (8) für mehrere Prozeßgeräte (9) und/oder Prozeßflächen angeschlossen sind und der vom Plenum (6) des Reinraumes (11) getrennt ist.

2. Reinraum nach Anspruch 1,
**dadurch gekennzeichnet, daß** dem Ansauggerät (1) mindestens ein Ent/Befeuchtungsgerät (16) nachgeordnet ist, das vorzugsweise Teil des Ansauggerätes (1) ist.

3. Reinraum nach Anspruch 1 oder 2,
**dadurch gekennzeichnet, daß** dem Ansauggerät (1) mindestens ein vorteilhaft in Strömungsrichtung hinter dem Ent/Befeuchtungsgerät (16) liegender Wärmeübertrager (17) nachgeschaltet ist.

4. Reinraum nach einem der Ansprüche 1 bis 3,
**dadurch gekennzeichnet, daß** das gasförmige Medium durch wenigstens eine Filtereinheit (4) strömt, die vorteilhaft wenigstens eine, vorzugsweise mehrere Filterstufen (21 bis 24) aufweist.

5. Reinraum nach Anspruch 4,
**dadurch gekennzeichnet, daß** wenigstens eine Filterstufe (21) saure Filterkomponenten zum Abfangen von basischen Bestandteilen im gasförmigen Medium aufweist.

6. Reinraum nach Anspruch 4 oder 5,
**dadurch gekennzeichnet, daß** wenigstens eine Filterstufe (22) basische Filterkomponenten zum Abfangen von sauren Bestandteilen im gasförmigen Medium aufweist.

7. Reinraum nach einem der Ansprüche 4 bis 6,
**dadurch gekennzeichnet, daß** wenigstens eine Filterstufe (24) organische Filterbestandteile zum Auffangen organischer Bestandteile im gasförmigen Medium aufweist.

8. Reinraum nach einem der Ansprüche 4 bis 7,
**dadurch gekennzeichnet, daß** wenigstens eine Filterstufe (23) zum Abfangen von Partikeln im gasförmigen Medium vorgesehen ist.

9. Reinraum nach einem der Ansprüche 1 bis 8,
**dadurch gekennzeichnet, daß** vom Zuführraum (5, 20) Leitungen (7) abgehen, die die Strömungsräume (8) mit dem Zuführraum (5, 20) verbinden.

10. Reinraum nach einem der Ansprüche 1 bis 9,
**dadurch gekennzeichnet, daß** das gasförmige Medium und die Reinluft in mindestens einen Sammelraum (14) strömen, der mit dem Plenum (6) strömungsverbunden ist.

11. Reinraum nach einem der Ansprüche 1 bis 10,
**dadurch gekennzeichnet, daß** das gasförmige Medium einem Transportweg (26) für das zu behandelnde Gut zuführbar ist, der vorteilhaft in einem in Richtung auf den Reinraumbereich (11) offenen Strömungsraum (27) liegt, der vorzugsweise mit dem Zuführraum (5, 20) strömungsverbunden ist.

12. Reinraum nach einem der Ansprüche 1 bis 11,
**dadurch gekennzeichnet, daß** das gasförmige Medium atmosphärische Luft ist.

## Claims

1. Clean room, through which clean air/circulating air flows and in which at least one processing device (9) and/or at least one processing area are situated, which device and/or area can be supplied, via at least one intake device (1) to which a collecting channel (2) is connected, with a gaseous medium of known composition via a flow chamber (8), which medium can be supplied separately from the circulating air,
**characterised in that** the collecting channel (2) is flow-connected to a supply chamber (5, 20), to which a plurality of flow chambers (8) for a plurality of processing devices (9) and/or processing areas are connected and which is separated from the plenum (6) of the clean-room (11).

2. Clean room according to Claim 1,
**characterised in that** at least one dehumidifying/humidifying device (16) is arranged downstream of the intake device (1), and is preferably part of the intake device (1).

3. Clean room according to Claim 1 or 2,
**characterised in that** at least one heat exchanger (17) is arranged downstream of the intake device (1), and advantageously lies, in the flow direction, downstream of the dehumidifying/humidifying device (16).

4. Clean room according to one of Claims 1 to 3,
**characterised in that** the gaseous medium flows through at least one filter unit (4), which advantageously has at least one filter stage, preferably a plurality of filter stages (21 to 24).

5. Clean room according to Claim 4,
**characterised in that** at least one filter stage (21) has acidic filter components for catching basic constituents in the gaseous medium.

6. Clean room according to Claim 4 or 5,
**characterised in that** at least one filter stage (22) has basic filter components for catching acidic constituents in the gaseous medium.

7. Clean room according to one of Claims 4 to 6,
**characterised in that** at least one filter stage (24) has organic filter components for catching organic constituents in the gaseous medium.

8. Clean room according to one of Claims 4 to 7,
**characterised in that** at least one filter stage (23) is provided for catching particles in the gaseous medium.

9. Clean room according to one of Claims 1 to 8,
**characterised in that** lines (7) lead off from the supply chamber (5, 20), the lines connecting the flow chambers (8) to the supply chamber (5, 20).

10. Clean room according to one of Claims 1 to 9,
**characterised in that** the gaseous medium and the clean air flow into at least one collecting chamber (14), which is flow-connected to the plenum (6).

11. Clean room according to one of Claims 1 to 10,
**characterised in that** the gaseous medium can be supplied to a transport means (26) for the articles to be treated, the means advantageously lying in a flow chamber (27) which is open towards the clean-room region (11) and which is preferably flow-connected to the supply chamber (5, 20).

12. Clean room according to one of Claims 1 to 11,
**characterised in that** the gaseous medium is atmospheric air.

## Revendications

1. Salle blanche traversée par un flux d'air pur ou air de circulation, dans laquelle se situent au moins un dispositif de traitement (9) et/ou au moins une surface de traitement, vers lesquels, par l'intermédiaire d'au moins un dispositif d'aspiration (1), auquel est raccordé un conduit collecteur (2), peut être acheminé en passant par une chambre de circulation (8) un fluide gazeux avec une composition connue, qui peut être acheminé séparément de l'air de circulation, **caractérisée en ce que** le conduit collecteur (2) est relié à une chambre d'admission (5, 20), à laquelle sont raccordées plusieurs chambres de circulation (8) pour plusieurs dispositifs de traitement (9) et/ou surfaces de traitement, et laquelle est séparée de la chambre de répartition de l'air (6) de la salle blanche (11).

2. Salle blanche selon la revendication 1, **caractérisée en ce qu'**au moins un dispositif de déshumidification ou d'humidification (16) est monté en aval du dispositif d'aspiration (1) et, de préférence, constitue une partie du dispositif d'aspiration (1).

3. Salle blanche selon la revendication 1 ou 2, **caractérisée en ce qu'**au moins un échangeur de chaleur (17), situé avantageusement dans le sens d'écoulement en aval du dispositif de déshumidification ou d'humidification (16), est monté en aval du dispositif d'aspiration (1).

4. Salle blanche selon l'une quelconque des revendications 1 à 3, **caractérisée en ce que** le fluide gazeux circule à travers au moins une unité de filtrage (4) qui, de manière avantageuse, comporte au moins un, de préférence plusieurs niveaux de filtrage (21 à 24).

5. Salle blanche selon la revendication 4, **caractérisée en ce qu'**au moins un niveau de filtrage (21) comporte des composants de filtrage acides destinés à intercepter des composants basiques dans le fluide gazeux.

6. Salle blanche selon la revendication 4 ou 5, **caractérisée en ce qu'**au moins un niveau de filtrage (22) comporte des composants de filtrage basiques destinés à intercepter des composants acides dans le fluide gazeux.

7. Salle blanche selon l'une quelconque des revendications 4 à 6, **caractérisée en ce qu'**au moins un niveau de filtrage (24) comporte des composants de filtrage organiques destinés à intercepter des composants organiques dans le fluide gazeux.

8. Salle blanche selon l'une quelconque des revendications 4 à 7, **caractérisé en ce qu'**au moins un niveau de filtrage (23) est prévu pour intercepter des particules dans le fluide gazeux.

9. Salle blanche selon l'une quelconque des revendications 1 à 8, **caractérisée en ce que** des conduites (7) partent de la chambre d'admission (5, 20) et relient les chambres de circulation (8) à la chambre d'admission (5, 20).

10. Salle blanche selon l'une quelconque des revendications 1 à 9, **caractérisée en ce que** le fluide gazeux et l'air pur affluent dans au moins un espace collecteur (14), qui est relié en écoulement à la chambre de répartition de l'air (6) .

11. Salle blanche selon l'une quelconque des revendications 1 à 10, **caractérisée en ce que** le fluide gazeux peut être acheminé vers une voie de transport (26) pour le produit à traiter, qui est situé avantageusement dans une chambre de circulation (27), qui est ouverte dans la direction vers la salle blanche (11) et qui est reliée en écoulement à la chambre d'admission (5, 20).

12. Salle blanche selon l'une quelconque des revendications 1 à 11, **caractérisée en ce que** le fluide gazeux est l'air atmosphérique.
